# DEMANDE DE BREVET EUROPEEN

(11) **EP 0 899 838 A1**
(43) Date de publication de la demande: **03.03.1999**
(21) Numéro de dépôt: 98402099.0
(22) Date de dépôt: 24.08.1998
(51) Int. Cl.: H01S 3/25

(54) **Dispositif semi-conducteur d'amplification optique**

(30) Priorité: 01.09.1997 FR 9710843
(71) Demandeur: ALCATEL, 75008 Paris (FR)
(72) Inventeur: Dagens, Béatrice, 75014 Paris (FR); Janz, Christopher, 92130 Issy Les Moulineaux (FR)
(74) Mandataire: Smith, Bradford Lee

(57) **Abrégé**

Afin d'augmenter très fortement son seuil de saturation sans dégrader son gain, tout en restant compatible avec n'importe quelle technologie ou structure amplificatrice semiconductrice, le dispositif comporte :
- un coupleur d'entrée (Kx) muni d'un port d'entrée (X) et de q ports de sortie (B1-B4),
- un coupleur de sortie (Ky) muni de q ports d'entrée (C1-C4) et d'un port de sortie (Y),
les q ports de sortie (B1-B4) du coupleur d'entrée (Kx) étant reliés respectivement aux q ports d'entrée (C1-C4) du coupleur de sortie (Ky) par l'intermédiaire de q amplificateurs optiques semi-conducteurs (A1-A4) de mêmes caractéristiques d'amplification.

Application à la transmission de signaux optiques et pour réaliser des dispositifs de commutation "tout optiques".

## Description

L'invention se situe dans le domaine des amplificateurs optiques et concerne plus particulièrement les amplificateurs optiques semi-conducteurs.

Les amplificateurs optiques sont couramment utilisés pour la transmission de signaux optiques ainsi que pour réaliser des dispositifs de commutation "tout optiques".

La caractéristique essentielle d'un amplificateur optique est son gain défini comme le rapport de la puissance optique qu'il fournit en sortie à la puissance optique qu'il reçoit en entrée. Pour les faibles puissances optiques, le gain est constant et l'amplificateur fonctionne en régime linéaire. Par contre, à partir d'un certain niveau de puissance appliquée, la valeur du gain diminue au fur et à mesure que la puissance augmente. Ainsi, une autre caractéristique d'un amplificateur est sa puissance de seuil de sortie définie comme la puissance de sortie pour laquelle le gain a une valeur égale à la moitié du gain de l'amplificateur lorsque ce dernier n'est pas saturé (gain non saturé).

Le phénomène de saturation est particulièrement sensible dans le cas des amplificateurs optiques semi-conducteurs. Aussi, pour les applications où on a besoin d'un fonctionnement linéaire et d'une forte puissance, il convient que la puissance de saturation de l'amplificateur soit la plus élevée possible.

Une solution à ce problème consiste à optimiser le dimensionnement du composant et la composition des couches semi-conductrices qui le constituent ou bien à adopter des structures actives complexes telles que les puits quantiques multiples. Par exemple, en élargissant la partie guidante de la couche active, on diminue la densité de puissance, ce qui permet d'augmenter le seuil. Cette solution est toutefois limitée par le fait que l'on cherche généralement à conserver au guide de l'amplificateur une structure monomode.

Une autre solution consiste à utiliser un amplificateur à gain stabilisé tel que décrit par exemple dans la demande de brevet européen EP-A-639876, publiée le 22 février 1995. Cette solution permet bien d'étendre la plage de fonctionnement linéaire de l'amplificateur mais de façon limitée et au détriment du gain utile.

L'invention a pour but d'échapper aux limitations des méthodes évoquées ci-dessus. Pour cela, elle propose une solution permettant d'augmenter très fortement le seuil de saturation sans dégrader le gain, tout en restant compatible avec n'importe quelle technologie ou structure amplificatrice semi-conductrice.

Plus précisément, l'invention a pour objet un dispositif semi-conducteur d'amplification optique caractérisé en ce qu'il comporte :
- un coupleur d'entrée muni d'au moins un premier port d'entrée et d'au moins q premiers ports de sortie, ledit coupleur d'entrée étant apte à transformer une onde optique d'entrée appliquée audit premier port d'entrée en q ondes optiques secondaires focalisées respectivement sur lesdits q premiers ports de sortie et ayant chacune une puissance optique proportionnelle à la puissance de ladite onde d'entrée,
- un coupleur de sortie muni d'au moins q seconds ports d'entrée et d'au moins un second port de sortie, ledit coupleur de sortie étant apte à transformer lesdites q ondes secondaires qui seraient appliquées respectivement auxdits q seconds ports d'entrée en une onde optique de sortie focalisée sur ledit second port de sortie et ayant les mêmes caractéristiques modales que ladite onde d'entrée,
et en ce que lesdits q premiers ports de sortie du coupleur d'entrée sont reliés respectivement auxdits q seconds ports d'entrée du coupleur de sortie par l'intermédiaire d'amplificateurs optiques de mêmes caractéristiques d'amplification.

Ainsi, par comparaison avec un amplificateur classique de même gain non saturé, le dispositif selon l'invention permet en principe d'atteindre une puissance de saturation q fois plus élevée.

Selon un mode de réalisation préféré qui assure la compacité du dispositif, les coupleurs d'entrée et/ou de sortie sont constitués de guides multimodes.

Selon un autre aspect de réalisation, le dispositif est réalisé sous la forme d'un composant intégré, par exemple sur un substrat de phosphure d'indium. Une réalisation intégrée présente l'avantage d'assurer un minimum de pertes et une homogénéité des caractéristiques optiques et électriques des guides des amplificateurs.

La compacité des guides multimodes autorise en outre une réalisation intégrée simplifiée dite "tout active", c'est-à-dire selon laquelle les structures verticales des parties guidantes sont identiques sur tout le composant. Les coupleurs d'entrée et de sortie sont alors polarisés pour assurer leur transparence et fonctionnent donc en amplificateurs, mais la longueur des guides multimodes est suffisamment faible pour limiter les phénomènes de saturation au niveau du port de sortie du coupleur de sortie.

Selon un autre aspect de l'invention, le dispositif est adapté pour fonctionner en amplificateur à gain stabilisé. Pour cela, il comporte deux réflecteurs sélectifs en longueur d'onde couplés respectivement au port d'entrée du coupleur d'entrée et au port de sortie du coupleur de sortie de façon à former une cavité résonante apte à entretenir une oscillation de stabilisation de gain.

D'autres aspects et avantages de l'invention apparaîtront dans la suite de la description en référence aux figures.
- La figure 1 représente un exemple de structure verticale d'un amplificateur optique semi-conducteur.
- La figure 2 représente la caractéristique de gain d'un amplificateur semi-conducteur.
- La figure 3 représente un premier mode de réalisation du dispositif selon l'invention.
- La figure 4 représente un second mode de réalisation du dispositif selon l'invention.
- La figure 5 représente respectivement des courbes de gain du dispositif selon l'invention et d'un amplificateur semi-conducteur usuel.
- La figure 6 représente un dispositif d'amplification à gain stabilisé selon l'invention.

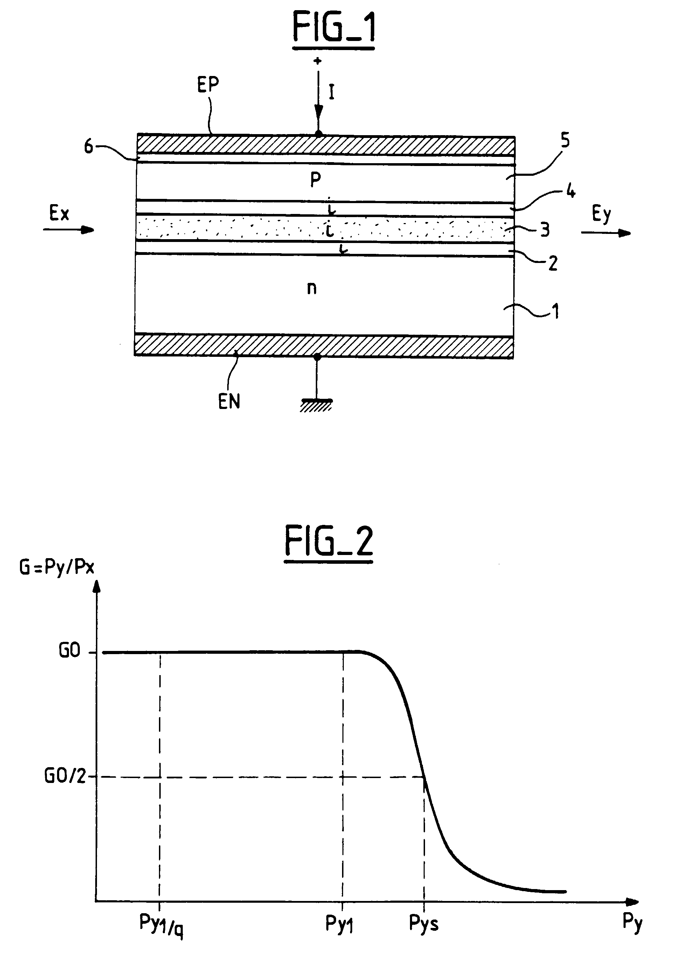

La figure 1 montre une coupe longitudinale au niveau de la couche active guidante d'un exemple de structure connue d'un amplificateur optique semi-conducteur. Cette structure peut servir à la mise en oeuvre de l'invention. L'amplificateur peut être réalisé sur un substrat d'éléments III-V. A titre d'illustration non limitative, on a choisi un substrat en phosphure d'indium InP et une structure de guide enterré.

Le substrat d'InP 1 qui a un indice égal à 3,17 est dopé n et on a formé sur celui-ci successivement :
- une couche de confinement inférieure 2 quaternaire InGaAsP non dopée, dont la composition est choisie pour présenter un indice égal à 3,32 et une longueur d'onde caractéristique (longueur d'onde de "gap") égale à 1,18 µm,
- une couche active 3 quaternaire non dopée, dont la composition est choisie pour présenter un indice égale à 3,51 et une longueur d'onde caractéristique égale à 1,55 µm,
- une couche de confinement supérieure 4 quaternaire InGaAsP non dopée, dont la composition est choisie pour présenter une valeur d'indice égale à 3,32 et une longueur d'onde caractéristique égale à 1,18 µm,
- une couche de phosphure d'indium 5 dopée p et
- une couche de contact 6 ternaire InGaAs fortement dopée p.

Le guide actif enterré a par exemple une largeur de 1,2 µm, de façon à assurer un fonctionnement monomode pour les longueurs d'onde usuelles en communications optiques.

Des électrodes supérieure EP et inférieure EN permettent d'injecter verticalement dans la structure un courant électrique de pompage I.

L'amplificateur est destiné à recevoir par une de ses faces une onde d'entrée Ex modulée en puissance et fournit une onde de sortie amplifiée Ey par la face opposée. Généralement, les faces d'entrée et de sortie sont réalisées par clivage d'une plaquette semi-conductrice qui comporte plusieurs amplificateurs et ces faces subissent ensuite un traitement antireflet.

La caractéristique de gain de la structure est représentée schématiquement à la figure 2. En appelant respectivement Px et Py les puissances optiques de l'onde d'entrée Ex et de l'onde de sortie Ey, le gain G = Py/Px varie en fonction de la puissance optique de sortie Py selon la courbe représentée. Pour les faibles valeurs de Py, le gain G a une valeur pratiquement constante GO appelé "gain non saturé". Si on augmente la puissance d'entrée Px, la puissance de sortie Py augmente mais au-delà d'une certaine valeur apparaît un phénomène de saturation et le gain diminue régulièrement. En pratique, on définit une puissance de saturation de sortie Pys pour laquelle le gain est égal à la moitié du gain non saturé GO. Ainsi, pour avoir un fonctionnement linéaire de l'amplificateur, il convient que la puissance de sortie Py reste constamment inférieure à cette puissance de saturation Pys.

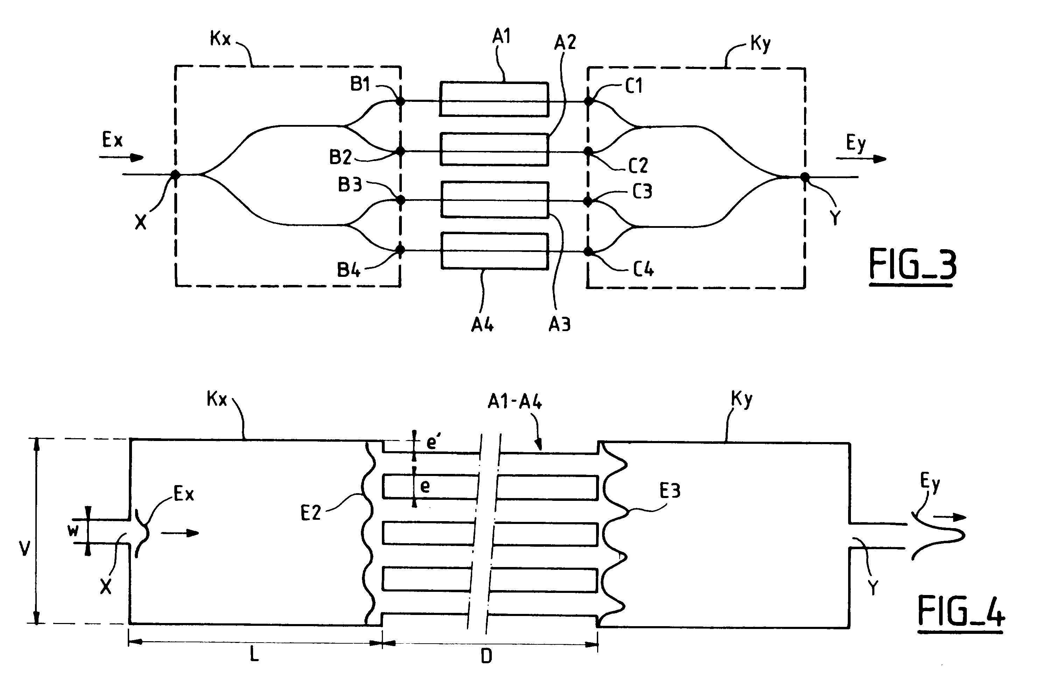

Un premier exemple de dispositif selon l'invention est représenté à la figure 3. Il comporte un coupleur d'entrée Kx muni d'un port d'entrée X et de plusieurs ports de sortie B1-B4. Selon l'exemple représenté, on a 4 ports de sortie mais dans le cas général on pourra avoir un nombre q quelconque de ports. Le dispositif comporte d'autre part un coupleur de sortie Ky muni de q ports d'entrée C1-C4 et d'un port de sortie Y. Les ports de sortie B1-B4 sont reliés aux ports d'entrée C1-C4 par l'intermédiaire de q amplificateurs optiques semi-conducteurs A1-A4 de mêmes caractéristiques d'amplification.

Le coupleur d'entrée Kx est prévu pour transformer l'onde optique d'entrée Ex appliquée au port d'entrée X en q ondes optiques secondaires focalisées respectivement sur les q ports de sortie B1-B4. Chaque onde secondaire a une puissance optique proportionnelle à la puissance Px de l'onde d'entrée Ex. En première approximation, cette puissance vaut Px/q si on néglige les pertes.

Le coupleur de sortie Ky est prévu pour effectuer la transformation inverse.

Une réalisation possible consiste à utiliser des coupleurs "1 vers q" et "q vers 1" de structures identiques, à base par exemple de coupleurs "Y" disposés en cascade, comme représenté schématiquement sur la figure 3.

Ainsi, en négligeant les pertes de couplage, chaque amplificateur A1-A4 de gain G reçoit la puissance Px/q d'une onde optique secondaire et fournit la puissance G.Px/q à l'un des q ports d'entrée C1-C4 du coupleur de sortie Ky. Ce dernier délivre sur son port de sortie Y la puissance G.Px.

Afin de montrer l'intérêt du dispositif à l'égard du problème de saturation, nous allons comparer avec l'aide de la figure 2 son fonctionnement à celui d'un amplificateur semi-conducteur de type classique servant de référence. On suppose que le dispositif selon l'invention et l'amplificateur de référence utilisent la même technologie et les mêmes structures guidantes et sont conçus pour présenter un même gain non saturé G0. Cela suppose donc que chaque amplificateur A1-A4 est identique à l'amplificateur de référence.

Si l'on applique dans les deux cas une puissance d'entrée Pxl correspondant à une puissance de sortie Pyl inférieure au seuil de saturation de sortie Pys de l'amplificateur de référence (figure 2), on voit que dans le cas de l'invention, la puissance d'entrée de chaque amplificateur vaut Px1/q et sa puissance de sortie est donc q fois plus faible que celle de l'amplificateur de référence. Il en résulte que l'invention permet de rester en régime linéaire pour une puissance q fois plus élevée que dans le cas de l'amplificateur de référence.

Dans la réalisation de la figure 3, les coupleurs d'entrée et de sortie utilisent des coupleurs en Y qui présentent toutefois quelques inconvénients. En effet, si on veut limiter les pertes des coupleurs, il faut éviter que les guides qui les constituent présentent de fortes courbures. Cela a pour conséquence d'imposer une longueur minimale de chaque coupleur, par exemple de l'ordre de 100 µm. De telles longueurs interdisent en pratique la réalisation "tout active" évoquée précédemment.

Une autre contrainte est le fait que les guides du coupleur doivent en outre respecter des tracés très précis de façon à ne pas introduire de déséquilibre entre les différents chemins optiques suivis par les ondes.

Pour résoudre le problème de l'encombrement des coupleurs tout en assurant de faibles pertes, une variante plus intéressante consiste à réaliser ces coupleurs au moyen de guides multimodes. Les coupleurs de ce type sont appelés "coupleurs interférentiels multimodes" (de l'anglais "multimode interference coupler") ou bien "beam splitters". On peut en trouver une description détaillée par exemple dans l'article intitulé : "Novel 1-to-N way integrated optical beam splitters using symmetric mode mixing in GaAs/AlGaAs multimode waveguides", J. M. Heaton et al", Applied Physics Letters, vol. 61, n°15, 12 octobre 1992.

La figure 4 montre schématiquement le tracé, vu de dessus d'un dispositif d'amplification utilisant comme coupleurs d'entrée et de sortie Kx, Ky des coupleurs multimodes.

Comme représentée, l'onde d'entrée Ex appliquée à l'entrée X du coupleur multimode Kx se transforme en une onde multimode E2 qui, grâce à un dimensionnement approprié du coupleur présente des maximums de puissance optique au niveau de ses ports de sortie. Ces maximums sont guidés et amplifiés dans les guides amplificateurs A1-A4 puis appliqués respectivement aux ports d'entrée du coupleur multimode de sortie Ky. Il s'y forme alors une onde multimode amplifiée E3 qui subit ensuite la transformation inverse de celle de l'onde d'entrée Ex dans le coupleur Kx. Le port de sortie Y du coupleur Ky délivre alors l'onde de sortie Ey.

A titre d'illustration, on va maintenant donner un exemple particulier de réalisation utilisant des coupleurs multimodes, avec une structure toute active conforme à la figure 1, dans le cas où q = 4.

Tous les guides couplés aux entrées et aux sorties des coupleurs Kx, Ky sont monomodes et ont la même largeur w = 1,2 µm. Dans ces conditions, on a :
- longueur des guides multimodes : L = 54,75 µm
- largeur des guides multimodes : V = 9,6 µm
- longueur de chaque guide amplificateur : D = 270,5 µm
- espacement entre guides amplificateurs : e = 1,2 µm
- distance entre les bords latéraux des guides multimodes et les bords externes des guides amplificateurs d'extrémités : e' = 0,6 µm.

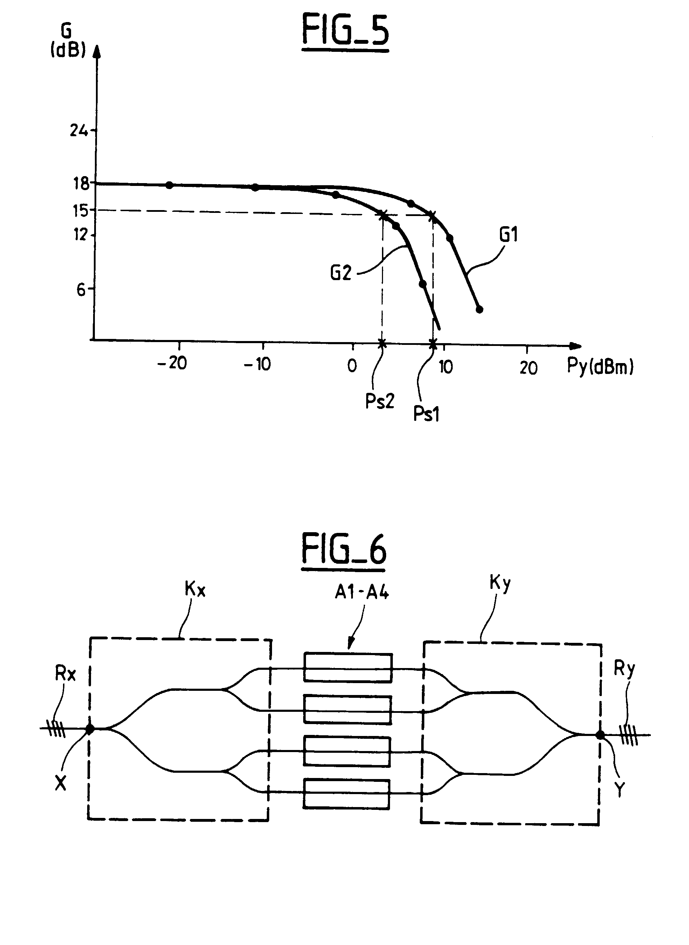

A titre de comparaison, la figure 5 montre les courbes de gain G1 et G2 calculées par simulation respectivement pour le dispositif d'amplification de la figure 4 dimensionné comme indiqué précédemment et pour un amplificateur classique de même technologie et de même gain non saturé. Les gains G1, G2 sont exprimés en décibels et la puissance de sortie est exprimée en dBm (10 fois le logarithme décimal de la puissance optique exprimée en milliwatts).

Ces courbes de simulation montrent que l'on a bien une différence d'environ 6 dB entre la puissance de saturation Ps1 du montage selon l'invention et celle Ps2 de l'amplificateur de référence.

Un autre aspect important du fonctionnement des amplificateurs semi-conducteurs est celui du bruit. On sait en effet que le rapport signal à bruit en sortie d'un amplificateur semi-conducteur se dégrade quand on l'utilise pour de faibles puissances. Ceci est dû au fait que le bruit provient en grande partie de l'émission spontanée amplifiée ("ASE") qui augmente lorsque la puissance optique d'entrée diminue.

Dans le cas du dispositif selon l'invention, pour une puissance d'entrée donnée Px, chacun des amplificateurs A1-A4 reçoit une puissance q fois plus faible que l'amplificateur de référence. Chaque amplificateur délivre donc un signal de sortie dont le rapport signal à bruit est dégradé. On peut cependant remarquer que la puissance du signal de sortie est, aux pertes près, q fois la puissance de sortie de chaque amplificateur parce que l'onde de sortie résulte d'interférences constructives des ondes issues des amplificateurs. Par contre, les bruits créés par les différents amplificateurs ne sont pas cohérents et, de leur combinaison dans le guide multimode de sortie, peut résulter une puissance de bruit inférieure à la somme des puissances de bruit des amplificateurs. De plus, si le dispositif est utilisé pour des niveaux de puissance suffisants pour faire fonctionner chaque amplificateur en régime linéaire au voisinage de son seuil de saturation, on pourra même obtenir une amélioration du rapport signal sur bruit par rapport à l'amplificateur de référence.

La figure 6 représente un dispositif d'amplification à gain stabilisé conforme à l'invention. La structure amplificatrice de base est la même que précédemment mais on a ajouté deux réflecteurs Rx et Ry couplés respectivement au port d'entrée X et au port de sortie Y. Les réflecteurs Rx et Ry sont par exemple des réseaux de Bragg dimensionnés pour réfléchir une longueur d'onde attribuée à une oscillation de stabilisation de gain, cette longueur d'onde étant différente de celle des ondes à amplifier. Par ailleurs, la structure amplificatrice proprement dite est dimensionnée pour entretenir une tel oscillation.

Le principe de fonctionnement du dispositif d'amplification à gain stabilisé selon l'invention est le même que pour l'amplificateur à gain stabilisé décrit dans la demande de brevet européen EP-A-639876 précitée.

Les exemples de réalisation de l'invention qui viennent d'être décrit utilisent tous des montages totalement symétriques, ce qui simplifie le dimensionnement et la fabrication. Il convient toutefois de remarquer que l'invention pourrait utiliser des montages non symétriques, par exemple avec un coupleur d'entrée présentant un nombre de ports de sortie supérieur au nombre d'amplificateurs. Dans ce cas, il convient de dimensionner le coupleur de sortie en conséquence pour qu'il reconstruise une onde de sortie de mêmes caractéristiques modale que l'onde d'entrée.

## Revendications

1. Dispositif semi-conducteur d'amplification optique caractérisé en ce qu'il comporte :
- un coupleur d'entrée (Kx) muni d'au moins un premier port d'entrée (X) et d'au moins q premiers ports de sortie (B1-B4), ledit coupleur d'entrée (Kx) étant apte à transformer une onde optique d'entrée (Ex) appliquée audit premier port d'entrée (X) en q ondes optiques secondaires (E2) focalisées respectivement sur lesdits q premiers ports de sortie (B1-B4) et ayant chacune une puissance optique proportionnelle à la puissance de ladite onde d'entrée (Ex),
- un coupleur de sortie (Ky) muni d'au moins q seconds ports d'entrée (C1-C4) et d'au moins un second port de sortie (Y), ledit coupleur de sortie (Ky) étant apte à transformer lesdites q ondes secondaires (E2) qui seraient appliquées respectivement auxdits q seconds ports d'entrée (C1-C4) en une onde optique de sortie (Ey) focalisée sur ledit second port de sortie (Y) et ayant les mêmes caractéristiques modales que ladite onde d'entrée (Ex),
et en ce que lesdits q premiers ports de sortie (B1-B4) du coupleur d'entrée (Kx) sont reliés respectivement auxdits q seconds ports d'entrée (C1-C4) du coupleur de sortie (Ky) par l'intermédiaire de q amplificateurs optiques (A1-A4) de mêmes caractéristiques d'amplification.

2. Dispositif selon la revendication 1, caractérisé en ce que lesdits coupleurs d'entrée et/ou de sortie (Kx, Ky) sont constitués de guides multimodes.

3. Dispositif selon la revendication 2, caractérisé en ce qu'il est réalisé sous la forme d'un composant intégré.

4. Dispositif selon la revendication 3, caractérisé en ce qu'il est intégré sur un substrat de phosphure d'indium.

5. Dispositif selon l'une des revendications 2 à 4, caractérisé en ce que lesdits coupleurs d'entrée et de sortie (Kx, Ky) ont des structures verticales identiques à celles des amplificateurs (A1-A4).

6. Dispositif selon l'une des revendications 1 à 5, caractérisé en ce que les amplificateurs (A1-A4) ont des structures identiques.

7. Dispositif selon l'une des revendications 1 à 6, caractérisé en ce qu'il comporte deux réflecteurs (Rx, Ry) sélectifs en longueur d'onde couplés respectivement au premier port d'entrée (X) et au second port de sortie (Y) de façon à former une cavité résonante et à entretenir une oscillation optique de stabilisation de gain.
